# EUROPEAN PATENT SPECIFICATION

(11) **EP 2 130 234 B1**
(45) Date of publication and mention of the grant of the patent: **29.10.2014**
(21) Application number: 08707800.2
(22) Date of filing: 25.02.2008
(51) Int. Cl.: H01L 31/18, C23C 14/18, C23C 14/30, C23C 14/58

(54) **CONTINUOUS COATING INSTALLATION AND METHOD FOR PRODUCING CRYSTALLINE THIN FILMS**
INSTALLATION EINER KONTINUIERLICHEN BESCHICHTUNG UND VERFAHREN ZUM HERSTELLEN VON KRISTALLINEN DÜNNFILMEN
INSTALLATION DE REVÊTEMENT EN CONTINU ET PROCÉDÉ DE PRODUCTION DE FILMS MINCES CRISTALLINS

(30) Priority: 27.02.2007 US 903739 P
(43) Date of publication of application: 09.12.2009
(73) Proprietor: Carl Zeiss Laser Optics GmbH, 73447 Oberkochen (DE); Carl Zeiss SMT GmbH, 73447 Oberkochen (DE)
(72) Inventor: SHAH, Arvind, CH-2022 Bevaix (CH); SCHADE, Horst, 82041 Deisenhofen (DE); MUENZ, Holger, 73433 Aalen (DE); VOELCKER, Martin, 89551 Königsbronn-Zang (DE); SCHALL, Michael, 73457 Essingen (DE); KRANTZ, Matthias, 24161 Altenholz (DE)
(86) International application number: PCT/EP2008/001465
(87) International publication number: WO 2008/104346

(56) References cited:
- EP-A- 0 609 867
- WO-A-2005/124841
- JP-A- 2 310 916
- JP-A- 6 260 436
- JP-A- 9 293 680
- JP-A- 2004 134 577
- US-A1- 2001 021 544
- US-A1- 2002 031 876
- US-A1- 2003 160 239
- US-A1- 2003 183 270
- US-A1- 2003 218 169
- US-A1- 2004 072 411
- US-A1- 2005 012 228

## Description

The invention relates to a continuous coating installation, in particular for producing nano-, micro-, poly-, multi- or monocrystalline thin films, referred to hereinafter generally as crystalline thin films. The invention furthermore relates to a method for producing crystalline thin films.
Semiconductor components used in microelectronics and photovoltaics are predominantly based on the semiconductor material silicon. The single-crystal semiconductor wafers which have predominantly been used since the 1960s and into which the corresponding structures are introduced are increasingly being replaced by thin films applied e.g. to glass substrates.

Different modifications of the silicon, namely amorphous or crystalline silicon, occur depending on the deposition method used for such thin films. The electronic properties of amorphous silicon differ significantly from those of crystalline silicon. On account of its optical/electronic properties and also on account of the possible deposition/production methods, amorphous silicon is suitable, in particular, for producing thin-film solar cells. Thin films composed of crystalline silicon are of interest both for microelectronics and for photovoltaics. Flat screens are nowadays already produced on the basis of amorphous or polycrystalline silicon layers.

A large number of methods are known which permit amorphous silicon layers to be deposited cost-effectively, in large-area fashion and with sufficient layer thickness. They include various chemical vapour deposition (CVD) processes and physical vapour deposition (PVD) processes, such as e.g. electron beam evaporation and cathode sputtering.

A large number of methods are also known for depositing crystalline thin films. In general, however, the deposition rates for producing the crystalline thin films are too low to be able to produce high-quality semiconductor structures cost-effectively. Thus, it is known e.g. from the prior art to produce finely crystalline silicon layers with the aid of chemical vapour deposition processes. In this case, however, the growth rate is only a few tens of nanometres per minute. Thin films produced by means of high-rate methods such as e.g. electron beam evaporation or cathode sputtering have an amorphous microstructure and are not readily suitable for electronic components.

The polycrystalline silicon films required for producing flat screens have layer thicknesses of between 50 and 100 nm. Polycrystalline thin films of this type can be produced from amorphous silicon films by thermal action or by irradiation with the aid of a high-power laser. Customary laser crystallization methods are the methods known by the respective following designations: laser zone melting, excimer laser annealing (ELA), sequential lateral solidification (SLS) and thin beam directional crystallization (TDX). Solid phase crystallization (SPC) and metal induced crystallization (MIC) and also halogen lamp and hot wire annealing (HW-CVD) are known among the thermal methods.

The process temperature and the glass substrate types therefore required are important with regard to the production costs. Excimer-laser-based crystallization methods and also ion beam assisted deposition (IAD) are possible on low-temperature substrates, while SPC and MIC require medium temperatures (~ 400 - 600°C). Details are described for example in A. Aberle, Thin Solid Films 511,26 (2006).

An absorber of a solar cell based on crystalline silicon requires a minimum layer thickness of 1 to 2 *µ*m. Thermal crystallization of an amorphous silicon film is not suitable for producing crystalline silicon layers having crystallites of significantly larger than ~ 1 *µ*m. with the aid of laser processes, although thin films having thicknesses of more than 200 nm can be crystallized, the difficulty consists in the process control. Details are described by e.g. M.A. Crowder et al. in "Sequential Lateral Solidification of PECVD and Sputter Deposited a-Si Films" Mat. Res. Soc. Symp. Proc. Vol 621 (2000), Q9.7.1.

JP 09-293680 A discloses a batch method in which alternately a thin film having a thickness of 100 to 200 nm composed of amorphous silicon is applied to a substrate with the aid of a plasma enhanced chemical vapour deposition (PECVD) process and said film is subsequently crystallized in the same vacuum chamber with the aid of an excimer laser beam. In this case, the laser beam is focused onto a location of the substrate and the substrate is moved to and fro under the laser beam with the aid of a belt guided by way of two rollers, such that gradually the entire surface of the substrate is crystallized by the laser beam.

JP 02-310916 discloses a coating installation in which first monosilane gas is blown towards a tubular cooling head made of copper so that a solidified substance of the gas is formed at an outer circumference of the cooling head. The surface of the cooling head is subsequently irradiated with an ion beam, and silane is being sputtered onto a glass substrate. Then, a local region of the sputtered region is irradiated with a laser beam, leading to a decomposition reaction of the sputtered silane SiH4 so that polycristalline silicon Si is precipitated.

It is indicated that instead of illuminating one location of the film, it is also possible for two, three or more locations to be illuminated simultaneously. By moving the substrate to and fro, the laser beams reach each location of the substrate.

While the alternatives illustrated in the figures relate exclusively to alternate deposition and illumination, it is expressly pointed out in the description that the two process steps of coating and illumination can also be carried out simultaneously. It is further mentioned that all types of CVD processes such as e.g. light-assisted CVD, thermally assisted CVD and plasma CVD as well PVD and cathode sputtering can be used for layer deposition. Details about the apparatuses to be used are not indicated.

G. Andrä et al. describe in the article "Diode Laser Crystallized Multicrystalline Silicon Thin Film Solar Cells on Glass", in Proc. of 21st European Photovoltaic Solar Energy Conference, 4-8 September 2006, Dresden, Germany, pages 972 to 975, the production of 2 to 5 *µ*m thick absorbers with the aid of a so-called layered laser crystallization (LLC) process. A first variant proceeds from a PECVD deposition of amorphous silicon (a-Si) with a thickness of 600 nm on glass. This layer is crystallized by means of a laser in the vacuum chamber. A 2 to 5 *µ*m thick a-Si layer is deposited onto this seed layer continuously by means of PECVD. In each case after the deposition of a film having a thickness of tens of nm, a crystallization is effected with the aid of a homogenized light beam of an excimer laser that is guided over the sample, without breaking the vacuum in the process (ISC-CVD, in-chamber seed crystallization by low power laser). A second variant proceeds from a seed layer crystallized outside the vacuum chamber by means of a high-power laser (ESC, external seed crystallization). A third variant described involves an epitaxial layer growth by electron beam evaporation and laser irradiation after respective deposition of 10 nm thin films. Details about the installation used are not indicated.

WO 02/19437 A2, which is attributed to the author of the paper indicated above, discloses producing a seed layer for the production of a polycrystalline absorber by means of electron beam evaporation and subsequent laser crystallization.

Although the abovementioned PVD deposition methods represent promising approaches for the mass production of high-quality crystalline silicon layers, a coating installation suitable for mass production does not currently exist yet. What is more, the number of necessary process steps for fabricating a large-area silicon layer with high crystal quality and in particular for producing a highly efficient silicon solar cell is still very high.

The object of the invention, therefore, is to provide a continuous coating installation suitable for depositing high-quality crystalline thin films, a corresponding method for producing crystalline thin films and solar cells and also a solar cell which can be produced e.g. by means of said method.

This object is achieved by means of a continuous coating installation having the features of claim 1 and by means of a method having the features of Claim 12. Advantageous embodiments and developments of the invention are specified in the subclaims.

According to the invention, the continuous coating installation comprises a vacuum chamber having a supply opening for supplying a substrate to be coated and a discharge opening - usually arranged opposite - for discharging the coated substrate. The supply and/or discharge openings can be part of a lock system. It is also possible for further coating and/or processing chambers to be adjacent to the supply and/or discharge openings.

A further part of the continuous coating installation is a physical vapour deposition device (that is to say a deposition device for carrying out a physical vapour deposition method) arranged in the vacuum chamber and serving for coating a surface of the substrate. The deposition device comprises an electron beam evaporation device or a cathode sputtering device. Also conceivable are thermal evaporation devices that permit the deposition of thin films up to a few micrometres with a high deposition rate (in comparison with customary CVD methods).

A laser crystallization system is furthermore provided, which is arranged in relation to the deposition device in such a way that a laser beam provided for the laser crystallization can be directed onto a sub-partial area of a partial area of the surface of the substrate that is currently being coated by means of the deposition device. It must therefore be possible for a laser crystallization of the layer deposited onto the sub-partial area to be effected simultaneously during the coating of the partial area of the substrate surface.

Finally, in a departure from the laboratory installations known from the prior art, the intention is for the substrate to be fed through the coating and laser crystallization zone within the vacuum chamber. For this purpose, the invention provides a transport device for transporting the substrate in a feedthrough direction from the supply opening to the discharge opening and for continuously or discontinuously, e.g. in stepwise fashion, moving the substrate during the coating thereof in the feedthrough direction. In principle, a reversal of the direction of movement can also take place for a predetermined period of time or else periodically, if appropriate, but the uncoated substrate is supplied through the supply opening and discharged through the discharge opening.

In one advantageous embodiment variant of the invention, a plurality of electron beam evaporation devices and/or a plurality of cathode sputtering devices are arranged alongside one another perpendicular to the feedthrough direction. By virtue of this measure, comparatively wide substrates can also be coated. It goes without saying that it is also possible for a plurality of PVD devices to be arranged one behind another in the feedthrough direction.

A further advantageous variant of the invention consists in the fact that the transport device has a movement device for moving the substrate in a direction that lies in a coating plane and runs at an angle, preferably perpendicular, to the feedthrough direction. It is thus possible for both the currently coated partial area and the sub-partial area of the substrate surface that is currently being illuminated by the laser crystallization system to be chosen independently of the feedthrough direction.

In the simplest case, the laser crystallization system is formed in rigid fashion. To put it another way, the laser beam or, if appropriate, laser beams emitted by the laser crystallization system are directed onto the substrate in a positionally fixed manner. Only the movement of the substrate in the feedthrough direction or, if appropriate, in a direction at an angle, in particular perpendicular, thereto leads to a change in the sub-partial areas exposed to the laser beam or laser beams. It is expedient e.g. to carry out the movement of the substrate in meandering fashion.

Instead of or in addition to a movement of the substrate by means of the transport device, it may be provided that the laser beam or laser beams required for crystallization also perform a movement. For this purpose, the laser crystallization system itself can have one or more laser beam movement devices that can be moved in at least one direction in order to guide at least one of the laser beams directed onto the substrate over the currently coated partial area independently of the movement of the substrate.

Depending on the arrangement, it is sufficient to provide only one movement in a linear direction. As the substrate size increases, it will be necessary for the at least one laser beam movement device to be embodied such that it can be moved in two directions running at an angle, preferably perpendicular to one another, in which case preferably one direction coincides with the feedthrough movement direction. It is expedient, in particular, if the laser beam describes a meandering path. Movements on curved movement paths are also conceivable. However, the latter movements, owing to their complexity, are generally taken into consideration only when they are necessary for process-technological reasons.

One preferred embodiment variant provides for the laser beam movement device to have a linear motor for linearly moving the at least one laser beam movement device.

In principle, it is possible to move the entire laser crystallization system. In order to keep the moved masses small, however, it is more expedient to move only individual optical components. A particularly advantageous configuration of the invention, which is distinguished by its simplicity and extensive minimization of the masses to be moved, provides for the at least one laser beam movement device to have a moveable mirror that deflects the at least one laser beam onto the at least one sub-partial area. Suitable arrangement of this or, if appropriate, the plurality of such deflection mirrors makes it possible to direct the laser beam or laser beams at each desired location on the substrate.

Instead of linear movement devices for the substrate and/or for the laser crystallization system or for optical components thereof, the laser crystallization system can have at least one laser angle scanner which can be rotated about at least one axis in order to direct the at least one laser beam onto the substrate from different directions. Such scanners are distinguished by the fact that very rapid changes in the current impingement location or current impingement locations of the laser beam or laser beams on the substrate are possible. This results from the fact that large changes in the impingement location on the substrate can be realized with small angular changes. While oscillating movements of the substrate and/or of the laser crystallization system or optical components thereof with amplitudes of a number of centimetres will be restricted to frequencies of a few hertz, angular scanning movements of a laser beam are possible with a frequency of thousands of hertz in the case of mechanical mirrors or holographic scanners and in the MHz range in the case of acousto-optical scanners.

In one particularly advantageous variant of the invention it is provided that the at least one laser angle scanner can be pivoted about at least one second axis. With a single laser beam, given a suitable arrangement of the axes with respect to one another (provided that there are no other obstacles) it is possible to illuminate each location on the substrate without the substrate itself needing to be moved.

Preferably, the laser crystallization system has at least one further laser angle scanner which is assigned to the at least one laser angle scanner and can be pivoted about at least one axis in order to direct the at least one laser beam onto the at least one laser angle scanner.

In one particularly advantageous embodiment variant of the invention, at least one imaging objective is provided in order to image the at least one laser beam onto the substrate surface in such a way that the contour and size of the sub-partial area illuminated by the laser beam remain essentially unchanged if the at least one laser beam is directed onto the substrate from different directions. The generation of a laser spot (generally in the form of a focus) that is independent of the irradiation direction in terms of contour and size is practical for setting a predetermined energy or power density distribution required for the laser crystallization on each location of the substrate. If the spot size (focus size) changed depending on the irradiation angle, there would be the risk of an inhomogeneous crystallization over the substrate area. What is more, part of the laser energy would possibly not contribute to the crystallization of the substrate.

One variant of a laser angle scanner and/or of a further laser angle scanner can have one or a multiplicity of galvo-mirrors or- scanners in order to deflect the at least one laser beam in a different manner. Rotating polygon scanners can also be used instead of one-or two-dimensional galvo-scanners. Polygon scanners can be operated at very high rotational speed, such that they enable scanning rates of more than 1000 Hz. Further variants of scanners are acousto-optical scanners and holographic scanners. The former permit high scanning rates, for example, and the latter permit different foki of the laser beam.

A further embodiment variant of the invention consists in the use of a multiplex device for generating a plurality of laser beams for simultaneously illuminating a plurality of sub-partial areas. The simultaneous illumination of a multiplicity of sub-partial areas has the advantage that, for the same spot scanning speed, either the feedthrough speed of the substrate or the deposition rate or both can be increased. All the measures lead to an increase in the throughput or to a reduction of the costs by virtue of less stringent requirements made of the optical system components.

In the simplest case, a multiplex device of this type can comprise a beam subdividing device for subdividing a laser beam into the plurality of laser beams. Roof prisms or multiple prisms as well as diffractive elements are examples of such beam subdividing devices. Assuming by way of example that the substrate surface forms a field plane onto which the laser beam or laser beams is or are imaged, said prisms are preferably arranged in a pupil plane.

A further variant of a continuous coating installation according to the invention comprises a deposition measuring device for measuring a deposition rate and/or a deposition quantity of a material deposited by the vapour deposition device, and also an open-loop and/or closed-loop control device for the open-loop and/or closed-loop control of the movement of the transport device and/or the laser beam movement device and thus for defining the location on the substrate onto which the (respective) laser beam is currently directed depending on the measured deposition rate and/or the measured deposition quantity. As an alternative or in addition, the open-loop and/or closed-loop control device can also be provided for the open-loop and/or closed-loop control of the current intensity of the at least one laser beam on the substrate depending on the measured deposition rate and/or the measured deposition quantity.

One advantageous embodiment of a continuous coating installation according to the invention comprises, as an alternative to the deposition measuring device described above or as an additional functional module, a layer thickness measuring device for measuring a layer thickness change and/or a layer thickness of the layer deposited on the substrate, e.g. by means of reflection or transmission at one or more wavelengths, ellipsometry or profilometry. The abovementioned open-loop and/or closed-loop control device or a corresponding open-loop and/or closed-loop control device is provided in accordance with this variant of the invention for effecting open-loop or closed-loop control of the movement of the transport device and/or the laser beam movement device and/or the current intensity of the at least one laser beam on the substrate depending on the measured layer thickness change and/or the measured layer thickness. The open-loop and/or closed-loop control of the movement of the transport device and/or the laser beam movement device defines the current location of the respective sub-partial area on the substrate, that is to say the location on the substrate onto which the respective laser beam is currently directed.

It goes without saying that the invention not only relates to a continuous coating installation as an overall system, rather it should be directly apparent to the person skilled in the art that the above-described variants of laser crystallization systems can also be operated by themselves, that is to say independently of a coating installation, or as part of a batch installation.

The method according to the invention for producing nano- micro-, poly- multi- or monocrystalline thin films, which achieves the above-specified object to its entire extent, comprises the following method steps:
a) supplying a substrate to be coated into a vacuum chamber in a feedthrough direction,
b) physical vapour deposition of a layer onto a partial area of a surface of the substrate and simultaneously at least partial melting and subsequent crystallization inducing illumination of at least one sub-partial area of the currently coated partial area of the surface of the substrate by means of at least one laser beam whilst continuously or discontinuously moving the substrate in the feedthrough direction,
c) discharging the coated substrate from the vacuum chamber in the feedthrough direction.

In this case, the method substep of a physical vapour deposition preferably comprises electron beam evaporation or cathode sputtering. In this case, it is expedient if the physical vapour deposition is carried out at a layer growth rate of more than 100 nm/min, preferably of more than 1000 nm/min, extremely preferably of more than 2000 nm/min. The deposition rate therefore differs considerably from customary CVD processes. Even the growth rates of layers deposited by plasma enhanced chemical vapour deposition (PECVD) processes lie at most at the lower limit of the range of values specified above.

On account of the high possible deposition rates of PVD processes generally and of electron beam evaporation and sputtering in particular, it is possible to move the substrate during method step b) in the feedthrough direction at an average speed of more than 0.5 m/min, preferably of more than 2 m/min, depending on the availability of commercial high-power lasers. The throughput time can therefore be significantly increased, which results in a considerable reduction of production costs.

In one advantageous method variant, the substrate is moved during method step b) in a direction that lies in a coating plane and is perpendicular to the feedthrough direction. Both the current location of the coating and the current location of the laser-induced crystallization of the substrate can be defined continuously in this way.

Preferably, the substrate is moved in oscillating fashion during method step b) in the direction that lies in the coating plane and is perpendicular to the feedthrough direction or in the feedthrough direction. Each desired part of the substrate is subjected (given a correspondingly adapted feedthrough speed) multiply to a coating and laser-induced crystallization process. In this case, the energy density of the laser beam or laser beams can optionally be set in such a way that the newly applied material only melts superficially, that the layer applied during a cycle melts over its entire layer thickness, or that one or more lower layers applied in previous cycles is or are even melted completely or over a fraction of its or their layer thickness.

The oscillating movement is preferably effected periodically at a frequency of 200 to 500 mHz. In this case, it may be advantageous if the forward movement takes place very slowly and the backward movement (e.g. along the same path) takes place very rapidly, that is to say e.g. in less than 1/100 or 1/1000 of the time of the forward movement. If different areas on the substrate are illuminated during forward and backward movements, e.g. if the laser beam progresses on a meandering path on the substrate, it is generally more favourable not to change the speed of the movement.

A particularly advantageous variant of the invention provides for the at least one of the laser beams to be guided over the currently coated partial area in a manner dependent on or independently of the movement of the substrate during method step b). Consequently, the respective laser beam is scanned over the surface of the substrate not only owing to the substrate's own movement, but on account of a movement of the laser beam.

It is particularly expedient if the at least one of the laser beams is guided over the currently coated partial area in a feedthrough direction of the substrate or at an angle, preferably a right angle, to the feedthrough direction.

Once again it is expedient if the movement is effected periodically. Scanning rates of 200 to 500 mHz or even higher are expedient depending on the respective deposition rates. In this case, too, it may be advantageous if the forward movement takes place very slowly and the backward movement takes place very rapidly, that is to say e.g. in less than 1/1000 or in less than 1/100000 of the time of the forward movement. It may be practical for the substrate to be illuminated only during the forward movement of the device that directs the laser beam onto the substrate, but not during the backward movement of said device. If the laser is operated in pulsed fashion, then it is only necessary to take care that the backward movement takes place precisely within the dead time within which no laser pulse is emitted.

This is different, of course, if the laser beam is guided on a meandering path over the substrate. A constant speed of the progressing laser spot on the substrate is to be preferred in this case.

It has proved to be particularly advantageous if the at least one of the laser beams is directed at that location of the substrate onto which precisely a predetermined layer thickness, e.g. between 50 nm and 1000 nm, preferably between 100 nm and 500 nm, extremely preferably between 100 nm and 300 nm, has been deposited. This operation can be repeated multiply in accordance with the above explanations until the final layer thickness is reached. The alternation of deposition and laser crystallization need not necessarily be effected in constant periods in this case. A particularly advantageous variant of the invention consists in laser-crystallising the bottommost layers on the substrate already after the growth of small layer thicknesses and, once a certain crystallized layer thickness has grown, in depositing a thicker layer by means of the PVD method before a further laser crystallization is initiated. It is particularly advantageous if the laser crystallization of the upper layers is carried out with low laser fluence in order to avoid melting of the underlying layers and mixing of dopings. It is thus expedient, for example, to crystallize the last n-type layer of a *µ*c-Si cell, i.e. the collector layer, with low laser fluence in order to avoid mixing with the dopings of the underlying i- or p- type layer(s).

The temperature of the substrate is preferably kept constant e.g. between 200°C and 400°C (depending on the glass substrate used) during method step b). This can be achieved, on the one hand, by means of an additional thermal heating and/or cooling of the substrate and/or by a corresponding adaptation of the laser fluence.

The method described above is suitable, in principle, for coating the substrate with virtually any desired material. Owing to the large field of application in electronics and photovoltaics, the method will no doubt preferably be applied for silicon.

The laser beam or the laser beams preferably has or have a wavelength of between 150 and 800 nm. In general, it suffices to illuminate the substrate by means of one or a plurality of lasers of a single wavelength. However, provision is also made for using lasers of different wavelengths. The corresponding laser beams can be directed simultaneously or successively onto the same location or the same locations of the substrate.

According to the invention, the laser wavelength depends on the different process windows of the individual method steps and the different respective structures of the electronic components to be produced. If production of an a-Si/ *µ*c-Si tandem solar cell is assumed, then the laser wavelength to be used depends concretely on the silicon microstructures of the different tandem cell types. The microstructure and morphology of the deposited Si, i.e. a-Si or already crystallized *µ*c-Si, determines together with the wavelength the absorption length and thus together with the laser power, the pulse duration (if appropriate also infinite when using a CW laser), the temporal pulse profile, the laser beam profile on the Si layer and the temporally varied reflectivity R thereof (Ra-si ≠ R_{*µ*c-Si} ≠ R_{liquid Si}), the 3-dimensional temperature profile in the Si layer. The absorption length of an excimer-laser-emitted light at e.g. 193 nm, 248 nm, 351 nm with typical pulse durations of ≈ 20 nsec is a few nanometres, while light from diode pumped solid state lasers (DPSSL), such as e.g. frequency-doubled Nd: YLF, Nd: YAG, or Nd: YVO₄ lasers, at 532 nm, is absorbed within significantly greater absorption lengths and therefore heats the layer more uniformly in the depth. Lower laser powers per cm² (i.e. laser fluences) are required for producing thin (seed) layers for example according to the SLS² methods. Therefore, according to the invention, it is particularly energy-efficient firstly to crystallize a thin seed layer by means of an excimer laser and then, by means of a laser having a longer wavelength (e.g. DPSSL), in a further step to crystallize a thicker a-Si layer deposited onto the seed layer. In the case of the tandem cell mentioned above, e.g. an excimer laser which emits light with a short absorption length can again be used for the final thin n-doped collector layer.

For the method described below of laser crystallization by means of "self propagating liquid layer", a pulsed long-wave laser is advantageous in order to produce a temperature profile in the depth of the layer which enables a longest possible propagation of the "liquid layer" and therefore a largest possible layer thickness per crystallization step before the process ends for energetic reasons. According to the invention, a preheating of the Si layer (e.g. by means of halogen lamps) in combination with a UV excimer laser is also possible here, although then only with glass substrates which withstand these temperatures. If appropriate, additional diffusion barriers can be provided in order to prevent the diffusion of impurities and dopings from the substrate into the solar cell or within the cell.

Depending on the layer thickness and wavelength, the laser fluencies are approximately 150-500 mJ/cm² for thin seed layers and the method with "self propagating liquid layer" and also ≈ 500-1500 mJ/cm² for the crystallization of thicker layers (100-500 nm) in the "complete melting" or "near complete melting" region, where "complete melting" relates to the a-Si layer and not to a previously crystallized underlying *µ*c-Si or PECVD a-Si layer.

It is particularly advantageous for high throughput and low production costs of the continuous coating installation for the laser radiation to be reflected back after reflection at the a-Si or melted Si layer by means of mirrors onto the same location again in order to increase the power or to reduce the required laser power under the same process conditions. On account of the high reflectivity of the melted silicon ≈ 50% depending on angle of incidence and wavelength, the efficiency of the installation can be increased by this "beam recycling".

The invention will now be described in more detail with reference to the drawing. Identical or functionally identical constituent parts of the devices illustrated in the various figures are provided with identical reference symbols. In the figures:
- Figure 1: shows a basic illustration of a continuous coating installation according to the invention for coating a substrate and subsequent laser crystallization of the deposited layer,
- Figure 2: shows the substrate in the continuous coating installation according to Figure 1 from below,
- Figure 3: shows a continuous coating installation according to the invention with a first embodiment variant of a laser crystallization device,
- Figure 4: shows a continuous coating installation according to the invention with a second embodiment variant of a laser crystallization device,
- Figure 5: shows a continuous coating installation according to the invention with a third embodiment variant of a laser crystallization device,
- Figure 6: shows a continuous coating installation according to the invention with a fourth embodiment variant of a laser crystallization device,
- Figure 7: shows a continuous coating installation according to the invention with a fifth embodiment variant of a laser crystallization device,

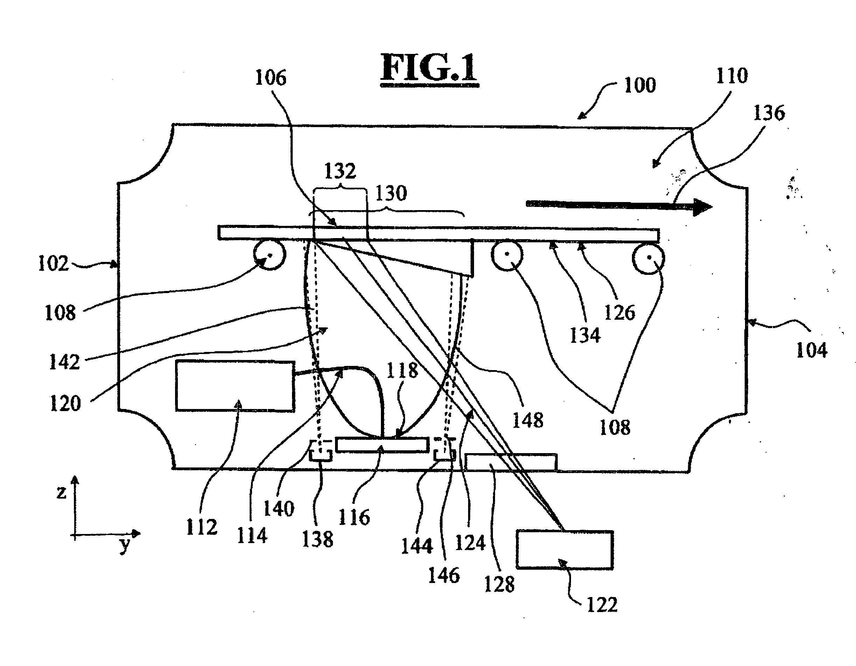

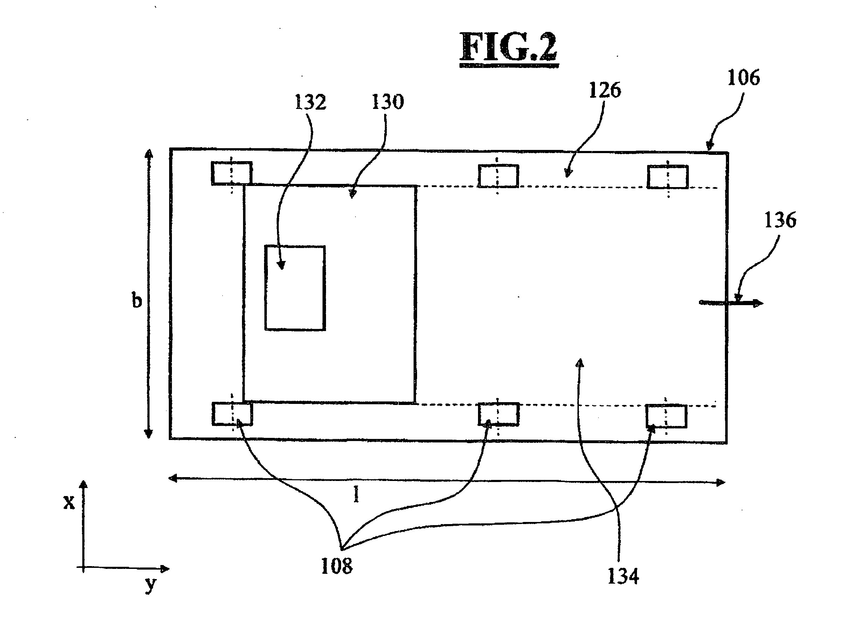

Figures 1 and 2 show the basic construction of a continuous coating installation 100 according to the invention from different viewing angles. Figure 1 shows a side view (yz plane), and Figure 2 shows a view from below (xy plane). The continuous coating installation 100 is embodied as a vacuum installation and accordingly comprises a vacuum chamber 110. The vacuum chamber 110 has a supply opening 102 and a discharge opening 104 arranged opposite. Adjacent to supply and/or discharge opening 102, 104 there may be in each case a lock system and/or a further process chamber, in particular a further vacuum chamber (not illustrated).

A further constituent part of the continuous coating installation 100 illustrated in Figures 1 and 2 is a substrate holder 108 with transport rollers. The substrate holder 108 serves, on the one hand, for the placement of a substrate 106 and, on the other hand, also as a transport device in order to transport the substrate 106 having an edge length 1 and a width b from the supply opening 102 in feedthrough direction 136 to the discharge opening 104.

An evaporator crucible 116 of an electron beam evaporation device 112 is arranged below the substrate holder 108. It is assumed that silicon 118 is situated in the evaporator crucible 116, which silicon can be evaporated by means of the electron beam 114 and deposits in a largely directional vapour jet 120 on the surface 126 of the substrate 106 facing the crucible 116. Instead of the electron beam evaporation device 112, a cathode sputtering device could also be provided, in which case the latter would more likely be situated above the substrate 106.

It is evident from Figures 1 and 2 of the drawing that the vapour jet 120 is directed only onto a partial area 130 of the surface 126 of the substrate 106. Since the substrate 106 is moved in feedthrough direction 136, the layer thickness deposited onto the substrate 106 by the device 112 increases within the partial area 130 from the side of the substrate 106 facing the supply opening 102 to the side of the partial area 130 facing the discharge opening 104 (linearly given constant feedthrough speed). A layer that has already reached the final layer thickness is situated on that part of the substrate 106 which has already emerged from the vapour jet 120. The corresponding partial area which has already been completely coated is identified by the reference symbol 134 in the drawing.

The drawing furthermore illustrates two effusion cells 138, 144 for doping with phosphorus (n-type conduction) or boron (p-type conduction). The effusion cells 138, 144 are not a necessary constituent part of the installation. They can be connected in optionally in the present exemplary embodiment. They are heated either electrically or with the aid of an electron beam. The effusion cells 138, 144 are designed in such a way that the doping impurity atoms impinge by means of geometrical shading and gap delimitation 140, 146 in spatially narrowly delimited vapour jets 142, 148 on narrow (a few centimetres wide) partial sections of the substrate. Transversely with respect to the feedthrough direction 136, the effusion cells 138, 144 have approximately the width b of the substrate 106.

A laser crystallization system 122 is provided according to the invention. The optical components of said laser crystallization system 122 are situated outside the vacuum chamber 110. Said laser crystallization system 122 emits a laser beam 124. Said laser beam 124 is directed through a chamber window 128 in the vacuum chamber 110 onto a location - referred to hereinafter as sub-partial area 132 - of the surface 126 of the substrate 106. Said sub-partial area 132 is part of the currently coated partial area 130 situated in the directed vapour jet 120, and if appropriate of the currently coated partial area 130 situated in the directed vapour jets 142, 148, of the surface 126 of the substrate 106.

According to the invention it is provided that the laser beam 124 is guided repeatedly over the simultaneously coated partial area 130 by means of a suitable movement of the substrate 106 and/or a suitable movement of the laser beam 124 during the layer deposition and/or the material melts at least part of its layer thickness, however. When the melted material cools down, crystallization takes place to form a layer having a fine-or coarse-grained structure, i.e. Si crystallites separated by grain boundaries.

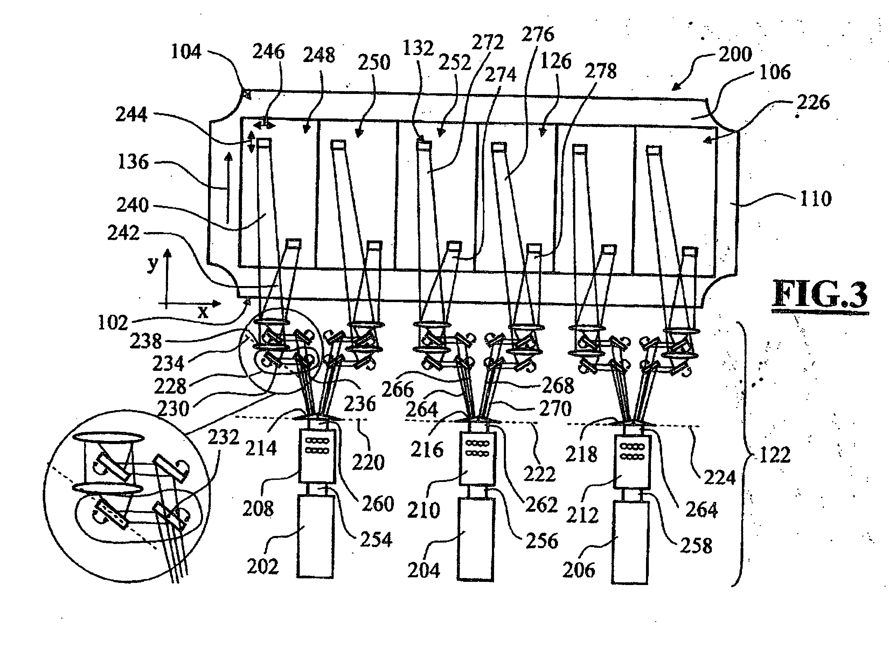

Figure 3 shows a coating installation 200 according to the invention with a first embodiment variant of a laser crystallization system 122. The basic illustration reveals a vacuum chamber 110 with supply and discharge opening 102, 104 and chamber window 128.

Constituent parts of the installation 200 are, alongside the laser crystallization system 122, a transport device (not illustrated here) and also a PVD coating device (likewise not illustrated) (if appropriate with effusion cell(s)) of the type shown in Figures 1 and 2.

In this embodiment variant according to Figure 3, the laser crystallization system 122 comprises three lasers 202, 204, 206. The latter emit laser beams 254, 256, 258 having a power of 300 watts, a pulse frequency of 300 hertz and a laser energy of one joule per pulse.

The laser beams 254, 256, 258 are respectively directed onto two-dimensional single-stage homogenizers 208, 210, 212. The homogenized laser beams 260, 262, 264 emerging from the homogenizers 208, 210, 212 on the output side respectively impinge on so-called quad prisms 214, 216, 218, where they are respectively subdivided into four partial beams having a correspondingly reduced power. Four of these subdivided laser beams are provided with the reference symbols 264, 266, 268 and 270, by way of example. These twelve subdivided laser beams 264, 266, 268, 270 are respectively directed via two-dimensional galvo-scanners 228 each having two galvo-mirrors 230, 232 and an objective 238 arranged in the chamber window plane onto the surface 226 of the substrate 106. The rotation axes 234, 236 of the galvo-mirrors 230, 232 are oriented with respect to one another in such a way that the respective laser beam 240, 242, 272, 274, 276, 278 deflected by the galvo-scanner 228 can be moved in substrate longitudinal direction 244 and in substrate transverse direction 246 over the surface 226 of the substrate 106.

Each of the twelve laser beams 240, 242, 272, 274, 276. 278 produces a respective spot size of 7 cm x 7 cm in the example given a working distance of 50 cm on the surface 226 of the substrate 106. Each laser spot can be guided over a partial field 248, 250, 252 of 20 cm x 20 cm of the surface 126 of the substrate 226.

For the SLS² or TDX² method described below for producing larger crystallites with fewer grain boundaries per cm² at the beginning of the laser crystallization on a PECVD a-Si layer, a line focusing of the laser beam in orthogonal directions successively, e.g. in x and y directions, is necessary. This is possible using the optical system according to Figure 3 by splitting the laser beam and producing different beam profiles by means of a plurality of homogenizers, i.e. one homogenizer for the line focus in the x direction (scanning direction x and y), a further homogenizer for the line focus in the y direction (scanning direction x and y) and also one homogenizer for the square laser profile described. However, rotation about the beam direction of a homogenizer, particularly in the case of combination of SLS and ELA, or rotation of the beam profile by means of prisms or plane mirrors is possible. In any case the laser power splitting of the lasers has to be matched to the process requirements of the individual processes. As an alternative, the SLS² method can be carried out with SLS slotted masks, although with lower efficiency. As an alternative and in a departure from the continuous concept, it is possible to rotate the substrate for implementing the SLS² or TDX₂ method.

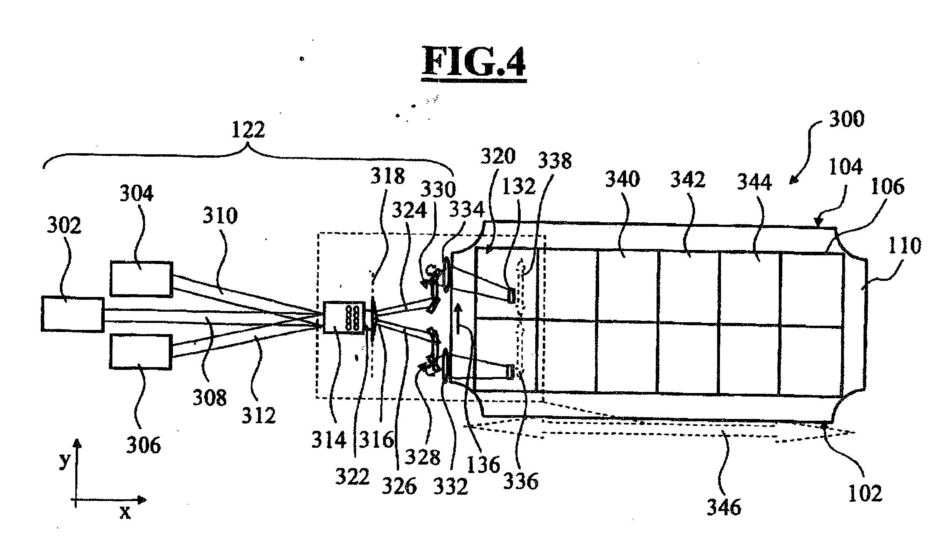

Figure 4 shows a further exemplary embodiment of a continuous coating installation 300 according to the invention. The vacuum chamber 110 with supply opening 102 and discharge opening 104 is once again depicted schematically. Situated in the interior of the vacuum chamber 110 there is once again a substrate 106, which can be moved in feedthrough direction 136 with the aid of a transport device (not illustrated) from the supply opening 102 to the discharge opening 104. A PVD coating device (not illustrated) is once again arranged within the vacuum chamber 110. A sputtering device which is arranged above the substrate 106 but is not depicted is assumed in the present case.

Through a chamber window 128 (not illustrated) in the cover of the vacuum chamber 110, it is possible to illuminate the substrate surface 320 by laser spots 132 produced by a laser crystallization device 122.

In the present exemplary embodiment, the laser crystallization device 122 comprises three lasers 302, 304, 306 having a power of in each case 300 watts, a repetition rate of 300 hertz and a pulse energy of 1 joule. The lasers 302, 304, 306 are pulsed in synchronized and intermittent fashion such that the arrangement illuminates the surface of the substrate 106 with an effective total pulse rate of 900 hertz.

The laser beams 308, 310, 312 emitted by the three lasers 302, 304, 306 are fed to a two-dimensional single-stage homogenizer 314 on the input side. The laser beam 322 homogenized by the homogenizer 314 is subdivided, with the aid of a roof prism 316 arranged in a pupil plane 318 (the field plane is situated on the substrate surface), into two partial beams 324, 326 having a correspondingly reduced laser power and is deflected in different directions.

Each partial laser beam 324, 326 is directed via a one-dimensional galvo-scanner 328, 330 onto an imaging objective 332, 334, which produces a laser beam profile 132 on the substrate 106. The laser beam profile size on the substrate 106 is 10 cm x 10 cm in the present exemplary embodiment. The galvo-scanners 328, 330 respectively enable the laser beam profiles 132 to be moved in and counter to the feed through direction 136. The corresponding directions of movement are indicated in the drawing by arrows provided with the reference symbols 336, 338. In this case, each of the two laser beam profiles 132 can scan half the substrate length 1. In order to be able to direct the laser beam profiles 132 onto each location of the substrate surface, provision is made according to the invention for the substrate 106 itself to be able to move to and fro perpendicular to the feedthrough direction 136. The possibility of movement to and fro is in turn illustrated in the drawing with the aid of a double-headed arrow 346.

The installation according to Figure 4 also makes it possible to simultaneously carry out different processes such as SLS, SLS² and ELA by rotating the beam profile (homogenizer), producing different beam profiles (e.g. linear and rectangular) and/or providing different distributions of the laser power between the two scanners 328, 330, e.g. by displacing the roof prism 316.

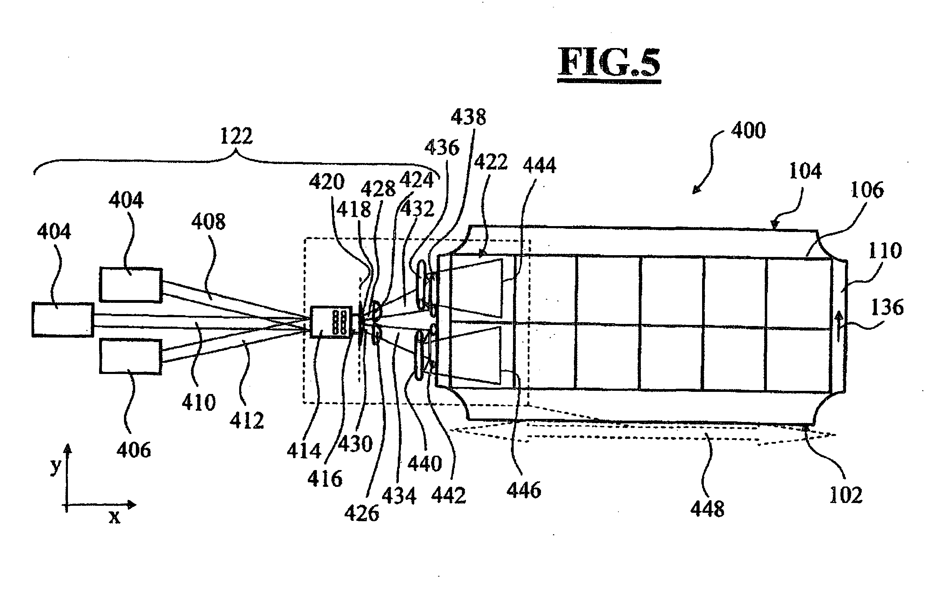

Figure 5 shows a further continuous coating installation 400 with a third embodiment variant of a laser crystallization device 122 according to the invention.

The continuous coating installation 400 again comprises a vacuum chamber 110 with a supply opening 102, via which a substrate 106 can be supplied in feedthrough direction 136, and with a discharge opening 104, via which the substrate 106 can be removed in feedthrough direction 136. A constituent part of the continuous coating installation 400 is once again a PVD coating device (not illustrated), which can be arranged above or below the substrate 106. In this respect, the continuous coating device 400 is identical to that according to Figure 4.

A third embodiment variant of a laser crystallization device 122 is depicted as a further constituent part of the continuous coating installation 400 in Figure 5 of the drawing. As in the previous exemplary embodiment, said laser crystallization device 122 comprises three lasers 402, 404, 406 having a power of 300 watts, a repetition rate of 300 hertz and a pulse energy of 1 J/pulse. The lasers 402, 404, 406 are synchronized and emit laser pulses in each case at a time interval of 1/3 of the total period duration of a laser 402, 404, 406. The laser beams 408, 410, 412 emitted by said lasers 402, 404, 406 are in turn directed onto a two-dimensional single-or two-stage homogenizer 414. The laser beam 416 homogenized by said homogenizer 414 subsequently impinges on a roof prism 418 arranged in a pupil plane 420 corresponding to the field plane assumed on the substrate area. Said roof prism 418 subdivides the homogenized laser beam 416 into two partial laser beams 428, 430 and deflects them in different directions in each case. The two partial laser beams 428, 430 respectively impinge on a beam expanding device 424, 426. Anamorphic lenses having a length of 20 cm are provided by way of example in the present exemplary embodiment. The expanded laser beams 432, 434 in turn impinge on a respective cylindrical lens objective (or alternatively on a cylindrical mirror objective) arranged in the chamber window 128 incorporated in the upper or lower part of the vacuum chamber 110 and having in each case two cylindrical lenses 436, 438, and 440, 442 arranged one behind another. These cylindrical lens objectives image the respective homogenized laser beam 432, 434 in reduced fashion, in each case forming an elongated illumination line with a defined homogenized beam profile 444, 446, onto the surface 126 of the substrate 106.

In the present exemplary embodiment, the length of an illumination line 444, 446 corresponds precisely to half the substrate length 1 in feedthrough direction 136. In practice, the lengths of the illumination lines 444, 446 will be chosen precisely such that together they correspond to the length of the partial area 130 of the surface of the substrate 106 which is exposed to the vapour jet 120 of the PVD device 112. The width of the illumination lines 444, 446 focused onto the substrate surface is 50 *µ*m given a working distance of 50 cm. In order to expose the entire surface 126 of the substrate 106 to the laser radiation of the two illumination lines 444, 446, the substrate 106 can in turn be moved to and fro perpendicular to its feedthrough movement direction 136 over its entire width b. The moveability is once again indicated with the aid of a double-headed arrow, identified by the reference symbol 448.

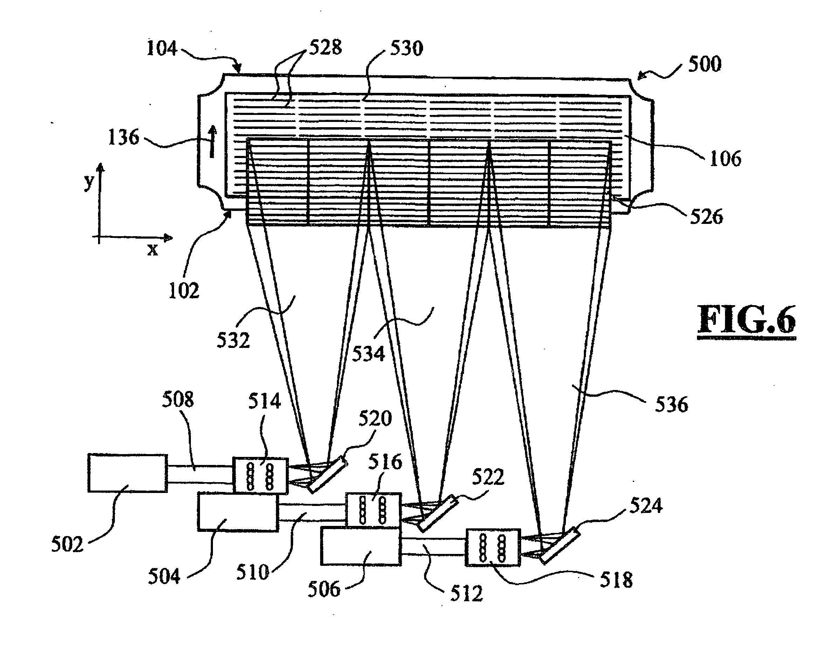

Figure 6 shows a further exemplary embodiment of a continuous coating installation 500 according to the invention. As in the examples described above, once again its vacuum chamber 110 with supply opening 102 and discharge opening 104 and also the laser crystallization device 122 are outlined schematically. The direction of movement of the substrate 106 is once again indicated with the aid of an arrow, identified by the reference symbol 136. The illustration does not show a PVD coating device likewise present and a chamber window through which the surface 126 nor of the substrate 106 is crystallized by means of a laser beam.

The laser crystallization device 122 once again comprises three lasers 502, 504, 506 each having a power of 300 watts, a pulse frequncy of 300 hertz and a laser energy of 1 J/pulse. The laser beams 508, 510, 512 emitted by said lasers 502, 504, 506 are homogenized independently of one another with the aid of corresponding two-dimensional single-or two-stage homogenizers 514, 516, 518 and, after their homogenization, are respectively fed to a deflection mirror 520, 522, 524. These deflection mirrors 520, 522, 524 expand the laser beams 532, 534, 536 to the size of a cylindrical lens arrangement 526 situated in the chamber window 128. Said cylindrical lens arrangement 526 focuses the laser beams 532, 534, 536 to form equidistantly arranged lines in the field plane 530 on the substrate. For this purpose, the cylindrical lens arrangement 526 comprises 14 x 6 = 84 cylindrical lenses. The 84 cylindrical lenses are curved differently such that all of the foci in the substrate plane have the same geometrical shape and the same intensity profile, namely a 20 cm x 36 *µ*m homogeneous line profile. This embodiment variant is distinguished by the fact that no moveable parts are present and that the installation can easily be scaled. Only one large chamber window is required and the dimensions of the installation overall are relatively large.

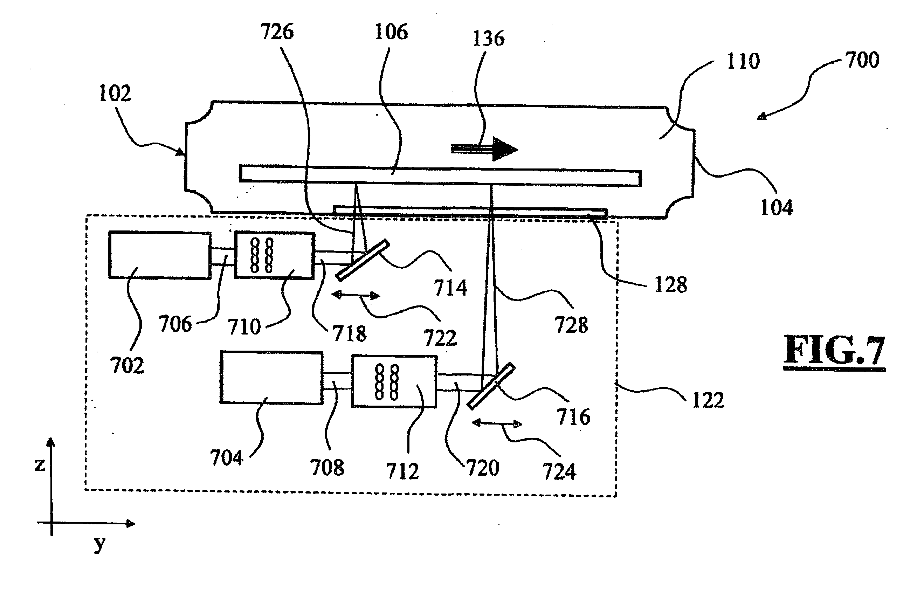

Figure 7 shows a further exemplary embodiment of a continuous coating installation 700 according to the invention. The figure of the drawing once again reveals the vacuum chamber 110 with supply opening 102 and discharge opening 104 for the substrate 106, and with a chamber window 128 through which laser light for the crystallization of a layer deposited on the substrate 106 can be coupled in. The substrate 106 is transported by a transport device (not illustrated here) in the y direction from the supply opening 102 to the discharge opening 104. The direction of movement is marked in Figure 7 by an arrow identified by the reference symbol 136.

The illustration here does not show the PVD coating system, which, in a similar manner to the embodiment variant illustrated in Figure 1, can comprise a plurality of electron beam evaporation devices 112 arranged in the x direction.

The laser crystallization device 122 is depicted in the present case. It comprises two lasers 702, 704, which can also be different laser types, i.e. excimer lasers and DPSSL (Diode Pumped Solid State Laser), CW or pulsed lasers having different wavelengths. The laser beams 706, 708 emitted by the lasers 702, 704 are homogenized with the aid of homogenizers 710, 712 and expanded in the x direction with the aid of an optical unit (not illustrated here). The expanded laser beams 718, 720 are directed onto the substrate 106 with the aid of deflection mirrors 714, 716. A focusing optical unit (likewise not illustrated here) before the chamber window 128 focuses the deflected laser beams 726, 728 onto the surface of the substrate 106. The two deflection mirrors 714, 716 can be moved linearly in the y direction. The linear moveability is respectively indicated in the figure of the drawing by a double-headed arrow identified by the reference symbols 722, 724. The laser beams 726, 728 directed through the chamber window 128 onto the substrate can be directed onto different locations of the surface of the substrate 106 with the aid of these linearly moveable deflection mirrors 714, 716 during coating.

Table 1 presented below summarizes the various possibilities of guiding a laser beam over the entire substrate surface.

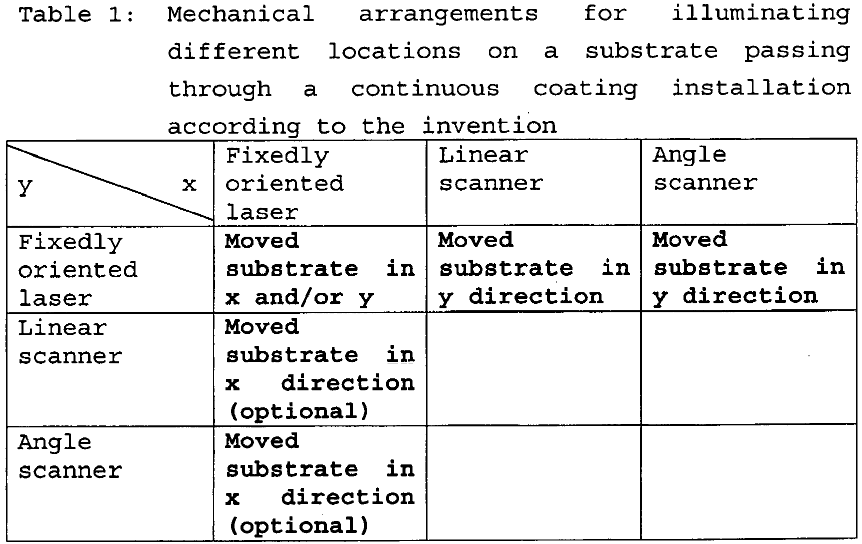

The first row and the first column of Table 1 respectively specify the device for moving the laser beam in the corresponding direction. It is assumed that the feedthrough direction of the substrate is the y direction.

To summarise, in each spatial direction x or y the laser beam can be immobile (column 2, row 2), be moved preferably linearly with the aid of a mechanical linear scanner (column 3, row 3) or be directed onto the substrate at different angles with the aid of an angle scanner (column 4, row 4). If the movement of the substrate is disregarded, then nine variants for the illumination of the substrate are produced by permutation.

If the possibility of moving the substrate in the x and/or y direction (movement only in x direction, movement in x and y direction) is additionally taken into consideration, the number of variants is doubled. Furthermore, there is the possibility of illuminating the substrate surface with only one homogenized laser profile or with a multiplicity thereof.

### List of Reference Symbols

- 100: Continuous coating installation
- 102: Supply opening
- 104: Discharge opening
- 106: Substrate
- 108: Substrate holder with transport rollers
- 110: Vacuum chamber
- 112: Electron beam evaporation device
- 114: Electron beam
- 116: Evaporator crucible
- 118: Silicon
- 120: Directed vapour jet
- 122: Laser crystallization (illumination) system
- 124: Laser beam
- 126: Surface of the substrate
- 128: Chamber window
- 130: Currently coated partial area
- 132: Currently illuminated sub-partial area, laser beam profile
- 134: Already coated partial area
- 136: Feedthrough direction
- 138: Effusion cell
- 140: Gap
- 142: Vapour jet
- 144: Effusion cell
- 146: Gap
- 148: Vapour jet

- 200: Continuous coating installation
- 202: Laser
- 204: Laser
- 206: Laser
- 208: Two-dimensional single-stage homogenizer
- 210: Two-dimensional single-stage homogenizer
- 212: Two-dimensional single-stage homogenizer
- 214: Quad prism
- 216: Quad prism
- 218: Quad prism
- 220: Pupil plane
- 222: Pupil plane
- 224: Pupil plane
- 226: Field plane
- 228: Two-dimensional galvo-scanner
- 230: Galvo-mirror
- 232: Galvo-mirror
- 234: Rotation axis
- 236: Rotation axis
- 238: Scanning objective
- 240: Laser beam
- 242: Laser beam
- 244: First scanning direction
- 246: Second scanning direction
- 248: Field
- 250: Field
- 252: Field
- 254: Laser beam
- 256: Laser beam
- 258: Laser beam
- 260: Homogenized laser beam
- 262: Homogenized laser beam
- 262: Homogenized laser beam
- 264: Subdivided laser beam
- 266: Subdivided laser beam
- 268: Subdivided laser beam
- 270: Subdivided laser beam
- 272: Laser beam imaged in field plane
- 274: Laser beam imaged in field plane
- 276: Laser beam imaged in field plane
- 278: Laser beam imaged in field plane

- 300: Continuous coating installation
- 302: Laser
- 304: Laser
- 306: Laser
- 308: Laser beam
- 310: Laser beam
- 312: Laser beam
- 314: Two-dimensional single-stage homogenizer
- 316: Roof prism
- 318: Pupil plane
- 320: Field plane
- 322: Homogenized laser beam
- 324: Subdivided and deflected laser beam
- 326: Subdivided and deflected laser beam
- 328: One-dimensional galvo-scanner
- 330: One-dimensional galvo-scanner
- 332: Scanning objective
- 334: Scanning objective
- 336: Scanning direction of the galvo-scanner
- 338: Scanning direction of the galvo-scanner
- 340: Field
- 342: Field
- 344: Field
- 346: Scanning direction of the substrate holder

- 400: Continuous coating installation
- 402: Laser
- 404: Laser
- 406: Laser
- 408: Laser beam
- 410: Laser beam
- 412: Laser beam
- 414: Two-dimensional two-stage homogenizer
- 416: Homogenized laser beam
- 418: Roof prism
- 420: Pupil plane
- 422: Field plane
- 424: Anamorphic objective
- 426: Anamorphic objective
- 428: Subdivided and deflected laser beam
- 430: Subdivided and deflected laser beam
- 432: Laser beam expanded in one direction and focused in one direction
- 434: Laser beam expanded in one direction and focused in one direction
- 436: Cylindrical lens
- 438: Cylindrical lens
- 440: Cylindrical lens
- 442: Cylindrical lens
- 444: Illumination line with short and long axis
- 446: Illumination line with short and long axis
- 448: Scanning direction of the substrate holder

- 500: Continuous coating installation
- 502: Laser
- 504: Laser
- 506: Laser
- 508: Laser beam
- 510: Laser beam
- 512: Laser beam
- 514: Two-dimensional two-stage homogenizer
- 516: Two-dimensional two-stage homogenizer
- 518: Two-dimensional two-stage homogenizer
- 520: Reflector
- 522: Reflector
- 524: Reflector
- 526: Cylindrical lens arrangement
- 528: Line foci
- 530: Field plane
- 532: Laser beam
- 534: Laser beam
- 536: Laser beam

- 700: Continuous coating installation
- 702: Laser
- 704: Laser
- 706: Laser beam
- 708: Laser beam
- 710: Homogenizer
- 712: Homogenizer
- 714: Scanning mirror
- 716: Scanning mirror
- 718: Homogenized laser beam
- 720: Homogenized laser beam
- 722: Scanning direction
- 724: Scanning direction
- 726: Laser beam
- 728: Laser beam

## Claims

1. Continuous coating installation (100, 200, 300, 400, 500, 700) comprising
- a vacuum chamber (110) having a supply opening (102) for supplying a substrate (106) to be coated and a discharge opening (101) for discharging the coated substrate (106),
- a deposition device (112) for coating a surface (126) of the substrate (106),
- a laser crystallization system (122) for simultaneously illuminating at least one sub-partial area (132) of a currently coated partial area (130) of the surface (126) of the substrate (106) with at least one laser beam (124),
- comprising a transport device (108) for transporting the substrate (106) in a feedthrough direction (136) from the supply opening (102) to the discharge opening (104) and for continuously or discontinuously moving the substrate (106) during the coating thereof in the feedthrough direction (136),
**characterized in that**
the deposition device (112) is a physical vapour deposition device (112) and the physical vapour deposition device (112) comprises at least one electron beam evaporation device (112) or at least one cathode sputtering device.

2. Continuous coating installation according to Claim 1, **characterized in that** a plurality of electron beam evaporation devices (112) and/or a plurality of cathode sputtering devices are arranged alongside one another perpendicular to the feedthrough direction (136).

3. Continuous coating installation according to one of Claims 1 or 2, **characterized in that** the laser crystallization system (122) has at least one laser beam movement device which can be moved in at least one direction (244, 246) in order to guide at least one of the laser beams (240, 242) over the currently coated partial area (130) independently of the movement of the substrate (106).

4. Continuous coating installation according to Claim 3, **characterized in that** the at least one laser beam movement device can be moved in two directions (244, 246) that are perpendicular to one another.

5. Continuous coating installation according to one of the preceding Claims, **characterized in that** the laser crystallization system (122) has at least one laser angle scanner (228) which can be pivoted about at least one axis (234, 236) in order to direct the at least one laser beam (240, 242, 272, 274, 276, 278) onto the substrate (106) from different directions.

6. Continuous coating installation according to Claim 5, **characterized in that** the at least one laser angle scanner (228) can be pivoted about at least one second axis (236).

7. Continuous coating installation according to either of Claims 5 and 6, **characterized in that** the laser crystallization system (122) has at least one further laser angle scanner (232) which is assigned to the at least one laser angle scanner (230) and can be pivoted about at least one axis (236) in order to direct the at least one laser beam (240, 242) onto the at least one laser angle scanner (230).

8. Continuous coating installation according to one of the preceding claims, **characterized in that** provision is made of a multiplex device (214, 216, 316, 418, 526) for generating a plurality of laser beams (264, 266, 268, 270) for simultaneously illuminating a plurality of sub-partial areas (132, 444, 446, 528).

9. Continuous coating installation according to Claim 8, **characterized in that** the multiplex device (214, 216, 316, 418, 526) is provided as a beam subdividing device (214, 216, 316, 418, 526) for subdividing a laser beam (260, 262, 264, 322, 416, 532, 534, 536) into the plurality of laser beams (264, 266, 268, 270, 324, 326, 428, 430).

10. Continuous coating installation according to one of the preceding claims, **characterized in that** provision is made of a deposition measuring device for measuring a deposition rate and/or a deposition quantity of a material (118) deposited by the vapour deposition device (112), and also an open-loop and/or closed-loop control device for the open-loop and/or closed-loop control of the current location of the sub-partial area (132) on the substrate (106) and/or the current intensity of the at least one laser beam (124) on the substrate (106) depending on the measured deposition rate and/or the measured deposition quantity.

11. Continuous coating installation according to one of the preceding claims, **characterized in that** provision is made of a layer thickness measuring device for measuring a layer thickness change and/or a layer thickness of the layer deposited on the substrate (106), and also an open-loop and/or closed-loop control device for the open-loop and/or closed-loop control of the current location of the sub-partial area (132) on the substrate (106) and/or the current intensity of the at least one laser beam (124) on the substrate (106) depending on the measured layer thickness change and/or the measured layer thickness.

12. Method for producing nano-, micro-, poly-, multi- or monocrystalline thin films comprising the following method steps:
a) supplying a substrate (106) to be coated into a vacuum chamber (110) in a feedthrough direction (136),
b) physical vapour deposition comprising electron beam evaporation or cathode sputtering of a layer onto a partial area (130) of a surface (126) of the substrate (106) and simultaneous laser crystallization of at least one sub-partial area (132) of the currently coated partial area (130) of the surface (126) of the substrate (106) by means of at least one laser beam (124) whilst continuously or discontinuously moving the substrate (106) in the feedthrough direction (136),
c) discharging the coated substrate (106) from the vacuum chamber (110) in the feedthrough direction (136).

13. Method according to claim 12, **characterized in that** the physical vapour deposition is carried out at a layer growth rate of more than 100 nm/min, preferably of more than 1000 nm/min, extremely preferably of more than 2000 nm/min.

14. Method according to one of Claims 12 to 13, **characterized in that** the substrate (106) is moved during method step b) in the feedthrough direction (136) at an average speed of more than 0.5 m/min, preferably of more than 2 m/min.

15. Method according to one of Claims 12 to 14, **characterized in that** the at least one of the laser beams (124) is directed at that location of the substrate (106) onto which precisely a predetermined layer thickness has been deposited.

16. Method according to Claim 15, **characterized in that** the predetermined layer thickness is between 50 nm and 1000 nm, preferably between 100 nm and 500 nm, extremely preferably between 100 nm and 300 nm.

17. Method according to either of Claims 15 and 16, **characterized in that** the at least one of the laser beams (124) is directed at that location (132, 444, 446) of the substrate (106) onto which precisely a further predetermined layer thickness has been deposited after an illumination with the at least one laser beam (124).

## Patentansprüche

1. Einrichtung zum kontinuierlichen Beschichten (100, 200, 300, 400, 500, 700), die Folgendes umfasst:
- eine Vakuumkammer (110) mit einer Zuführöffnung (102) zum Zuführen eines zu beschichtenden Substrats (106) und einer Ausstoßöffnung (101) zum Ausstoßen des zu beschichtenden Substrats (106),
- eine Beschichtungsvorrichtung (112) zum Beschichten einer Oberfläche (126) des Substrats (106),
- ein Laserkristallisationssystem (122) zum gleichzeitigen Beleuchten von zumindest einem Unterteilbereich (132) eines derzeit beschichteten Teilbereichs (130) der Oberfläche (126) des Substrats (106) mit mindestens einem Laserstrahl (124),
- mit einer Beförderungsvorrichtung (108) zum Befördern des Substrats (106) in eine Durchgangsrichtung (136) von der Zuführöffnung (102) zu der Ausstoßöffnung (104) und zum kontinuierlichen oder nicht kontinuierlichen Bewegen des Substrats (106) während seiner Beschichtung in der Durchgangsrichtung (136),
**dadurch gekennzeichnet, dass**
die Beschichtungsvorrichtung (112) eine Vorrichtung für eine physikalische Gasphasenabscheidung (112) ist und die Vorrichtung für die physikalische Gasphasenabscheidung (112) mindestens eine Elektronenstrahlverdampfungsvorrichtung (112) oder mindestens eine Kathodenzerstäubungsvorrichtung umfasst.

2. Einrichtung zum kontinuierlichen Beschichten nach Anspruch 1, **dadurch gekennzeichnet, dass** mehrere Elektron enstrahl verdampfungs vorrichtungen (112) und/oder mehrere Kathodenzerstäubungsvorrichtungen nebeneinander senkrecht zu der Durchgangsrichtung (136) angeordnet sind.

3. Einrichtung zum kontinuierlichen Beschichten nach Anspruch 1 oder 2, **dadurch gekennzeichnet, dass** das Laserkristallisationssystem (122) mindestens eine Laserstrahlbewegungsvorrichtung besitzt, die in mindestens eine Richtung (244, 246) bewegt werden kann, um mindestens einen der Laserstrahlen (240, 242) über den derzeit beschichteten Teilbereich (130) unabhängig von der Bewegung des Substrats (106) zu richten.

4. Einrichtung zum kontinuierlichen Beschichten nach Anspruch 3, **dadurch gekennzeichnet, dass** die mindestens eine Laserstrahlbewegungsvorrichtung in zwei Richtungen (244, 246), die senkrecht zueinander sind, bewegt werden kann.

5. Einrichtung zum kontinuierlichen Beschichten nach einem der vorhergehenden Ansprüche, **dadurch gekennzeichnet, dass** das Laserkristallisationssystem (122) mindestens einen Laserwinkelscanner (228) besitzt, der um mindestens eine Achse (234, 236) geschwenkt werden kann, um den mindestens einen Laserstrahl (240, 242, 272, 274, 276, 278) aus verschiedenen Richtungen auf das Substrat (106) zu richten.

6. Einrichtung zum kontinuierlichen Beschichten nach Anspruch 5, **dadurch gekennzeichnet, dass** der mindestens eine Laserwinkelscanner (228) um mindestens eine zweite Achse (236) geschwenkt werden kann.

7. Einrichtung zum kontinuierlichen Beschichten nach entweder Anspruch 5 oder 6, **dadurch gekennzeichnet, dass** das Laserkristallisationssystem (122) mindestens einen weiteren Laserwinkelscanner (232) besitzt, der dem mindestens einen Laserwinkelscanner (230) zugeordnet ist und um mindestens eine Achse (236) geschwenkt werden kann, um den mindestens einen Laserstrahl (240, 242) auf den mindestens einen Laserwinkelscanner (230) zu richten.

8. Einrichtung zum kontinuierlichen Beschichten nach einem der vorhergehenden Ansprüche, **dadurch gekennzeichnet, dass** eine Bereitstellung einer Multiplexvorrichtung (214, 216, 316, 418, 526) zum Erzeugen von mehreren Laserstrahlen (264, 266, 268, 270) zum gleichzeitigen Beleuchten von mehreren Unterteilbereichen (132, 444, 446, 528) gemacht wird.

9. Einrichtung zum kontinuierlichen Beschichten nach Anspruch 8, **dadurch gekennzeichnet, dass** die Multiplexvorrichtung (214, 216, 316, 418, 526) als eine Strahlunterteilungsvorrichtung (214, 216, 316, 418, 526) zum Unterteilen eines Laserstrahls (260, 262, 264, 322, 416, 532, 534, 536) in die mehreren Laserstrahlen (264, 266, 268, 270, 324, 326, 428, 430) bereitgestellt wird.

10. Einrichtung zum kontinuierlichen Beschichten nach einem der vorhergehenden Ansprüche, **dadurch gekennzeichnet, dass** ein Bereitstellen einer Beschichtungsmessvorrichtung zum Messen einer Beschichtungsrate und/oder eines Beschichtungsbetrags eines Materials (118), das durch die Gasphasenabscheidungsvorrichtung (112) aufgebracht wird, und auch einer Steuervorrichtung mit einer offenen Schleife und/oder einer geschlossenen Schleife für die Steuerung mit einer offenen Schleife und/oder die Steuerung mit einer geschlossenen Schleife des derzeitigen Orts des Unterteilbereichs (132) auf dem Substrat (106) und/oder der derzeitigen Stärke des mindestens einen Laserstrahls (124) auf dem Substrat (106) abhängig von der gemessenen Beschichtungsrate und/oder des gemessenen Beschichtungsbetrags erfolgt.

11. Einrichtung zum kontinuierlichen Beschichten nach einem der vorhergehenden Ansprüche, **dadurch gekennzeichnet, dass** ein Bereitstellen einer Schichtdickenmessvorrichtung zum Messen einer Schichtdickenänderung und/oder einer Schichtdicke der auf das Substrat (106) aufgebrachten Schicht und auch einer Steuerung mit einer offenen Schleife und/oder einer geschlossenen Schleife des derzeitigen Orts des Unterteilbereichs (132) auf dem Substrat (106) und/oder der derzeitigen Stärke des mindestens einen Laserstrahls (124) auf dem Substrat (106) abhängig von der gemessenen Schichtdickenänderung und/oder der gemessenen Schichtdicke erfolgt.

12. Verfahren zum Herstellen von nano-, mikro-, poly-, multi- oder monokristallinen dünnen Schichten, das die folgenden Schritte umfasst:
a) Zuführen eines zu beschichtenden Substrats (106) in einer Durchgangsrichtung (136) in eine Vakuumkammer (110),
b) physikalische Gasphasenabscheidung, die Elektronenstrahlverdampfung oder Kathodenzerstäuben einer Schicht auf einen Teilbereich (130) einer Oberfläche (126) des Substrats (106) und gleichzeitige Laserkristallisation von mindestens einem Unterteilbereich (132) des derzeit beschichteten Teilbereichs (130) der Oberfläche (126) des Substrats (106) mit Hilfe mindestens eines Laserstrahls (124) umfasst, während das Substrat (106) kontinuierlich oder nicht kontinuierlich in die Durchgangsrichtung (136) bewegt wird,
c) Ausstoßen des beschichteten Substrats (106) aus der Vakuumkammer (110) in der Durchgangsrichtung (136).

13. Verfahren nach Anspruch 12, **dadurch gekennzeichnet, dass** die physikalische Gasphasenabscheidung mit einer Schichtwachstumsrate von mehr als 100 nm/min, vorzugsweise mehr als 1000 nm/min, besonders bevorzugt mit mehr als 2000 nm/min, ausgeführt wird.

14. Verfahren nach einem der Ansprüche 12 bis 13, **dadurch gekennzeichnet, dass** das Substrat (106) während des Verfahrensschritts b) mit einer Durchschnittsgeschwindigkeit von mehr als 0,5 m/min, vorzugsweise mit mehr als 2 m/min in die Durchgangsrichtung (136) bewegt wird.

15. Verfahren nach einem der Ansprüche 12 bis 14, **dadurch gekennzeichnet, dass** der mindestens eine der Laserstrahlen (124) auf den Ort des Substrats (106), auf den genau eine vorgegebene Schichtdicke aufgebracht wurde, gerichtet wird.

16. Verfahren nach Anspruch 15, **dadurch gekennzeichnet, dass** die vorgegebene Schichtdicke zwischen 50 nm und 1000 nm, vorzugsweise zwischen 100 nm und 500 nm, besonders bevorzugt zwischen 100 nm und 300 nm, liegt.

17. Verfahren nach entweder Anspruch 15 oder 16, **dadurch gekennzeichnet, dass** der mindestens eine der Laserstrahlen (124) auf den Ort (132, 444, 446) des Substrats (106) gerichtet wird, auf den genau eine weitere vorgegebene Schichtdicke nach einer Beleuchtung mit dem mindestens einen Laserstrahl (124) aufgebracht wurde.

## Revendications

1. Installation de revêtement en continu (100, 200, 300, 400, 500, 700) comprenant
- une chambre à vide (110) comportant une ouverture d'introduction (102) pour introduire un substrat (106) à revêtir et une ouverture de décharge (101) pour décharger le substrat revêtu (106),
- un dispositif de dépôt (112) pour revêtir une surface (126) du substrat (106),
- un système de cristallisation à laser (122) pour éclairer simultanément au moins une sous-zone partielle (132) d'une zone partielle en cours de revêtement (130) de la surface (126) du substrat (106) avec au moins un faisceau laser (124),
- comprenant un dispositif de transport (108) pour transporter le substrat (106) dans une direction de traversée (136) depuis l'ouverture d'introduction (102) jusqu'à l'ouverture de décharge (104) et pour déplacer de façon continue ou discontinue le substrat (106) pendant le revêtement de celui-ci dans la direction de traversée (136),
**caractérisée en ce que**
le dispositif de dépôt (112) est un dispositif de dépôt physique en phase vapeur (112) et le dispositif de dépôt physique en phase vapeur (112) comprend au moins un dispositif d'évaporation par faisceau d'électrons (112) ou au moins un dispositif de pulvérisation cathodique.

2. Installation de revêtement en continu selon la revendication 1, **caractérisée en ce qu'**une pluralité de dispositifs d'évaporation par faisceau d'électrons (112) et/ou une pluralité de dispositifs de pulvérisation cathodique sont disposées côte à côte perpendiculairement à la direction de traversée (136).

3. Installation de revêtement en continu selon l'une des revendications 1 et 2, **caractérisée en ce que** le système de cristallisation à laser (122) comporte au moins un dispositif de déplacement de faisceau laser qui peut être déplacé dans au moins une direction (244, 246) afin de guider l'un au moins des faisceaux lasers (240, 242) sur la zone partielle en cours de revêtement (130) indépendamment du déplacement du substrat (106).

4. Installation de revêtement en continu selon la revendication 3, **caractérisée en ce que** l'au moins un dispositif de déplacement de faisceau laser peut être déplacé dans deux directions (244, 246) qui sont perpendiculaires l'une à l'autre.

5. Installation de revêtement en continu selon l'une des revendications précédentes, **caractérisée en ce que** le système de cristallisation à laser (122) comporte au moins un dispositif de balayage angulaire de laser (228) qu'on peut faire pivoter autour d'au moins un axe (234, 236) afin de diriger l'au moins un faisceau laser (240, 242, 272, 274, 276, 278) sur le substrat (106) depuis des directions différentes.

6. Installation de revêtement en continu selon la revendication 5, **caractérisée en ce qu'**on peut faire pivoter l'au moins un dispositif de balayage angulaire de laser (228) autour d'au moins un deuxième axe (236).

7. Installation de revêtement en continu selon l'une ou l'autre des revendications 5 et 6, **caractérisée en ce que** le système de cristallisation à laser (122) comporte au moins un autre dispositif de balayage angulaire de laser (232) qui est affecté à l'au moins, un dispositif de balayage angulaire de laser (230) et qu'on peut faire pivoter autour d'au moins un axe (236) afin de diriger l'au moins un faisceau laser (240, 242) sur l'au moins un dispositif de balayage angulaire de laser (230).

8. Installation de revêtement en continu selon l'une des revendications précédentes, **caractérisée en ce qu'**est fourni un dispositif multiplex (214, 216, 316, 418, 526) pour générer une pluralité de faisceaux lasers (264, 266, 268, 270) afin d'éclairer simultanément une pluralité de sous-zones partielles (132, 444, 446, 528).

9. Installation de revêtement en continu selon la revendication 8, **caractérisée en ce que** le dispositif multiplex (214, 216, 316, 418, 526) est fourni sous la forme d'un dispositif de subdivision de faisceau (214, 216, 316, 418, 526) pour subdiviser un faisceau laser (260, 262, 264, 322, 416, 532, 534, 536) en la pluralité de faisceaux lasers (264, 266, 268, 270, 324, 326, 428, 430).

10. Installation de revêtement en continu selon l'une des revendications précédentes, **caractérisée en ce qu'**est fourni un dispositif de mesure de dépôt pour mesurer une vitesse de dépôt et/ou une quantité de dépôt d'un matériau (118) déposé par le dispositif de dépôt en phase vapeur (112), et également un dispositif de contrôle en boucle ouverte et/ou en boucle fermée pour le contrôle en boucle ouverte et/ou en boucle fermée de l'emplacement courant de la sous-zone partielle (132) sur le substrat (106) et/ou de l'intensité courante de l'au moins un faisceau laser (124) sur le substrat (106) en fonction de la vitesse de dépôt mesurée et/ou de la quantité de dépôt mesurée.

11. Installation de revêtement en continu selon l'une des revendications précédentes, **caractérisée en ce qu'**est fourni un dispositif de mesure d'épaisseur de couche pour mesurer un changement d'épaisseur de couche et/ou une épaisseur de couche de la couche déposée sur le substrat (106), et également un dispositif de contrôle en boucle ouverte et/ou en boucle fermée pour le contrôle en boucle ouverte et/ou en boucle fermée de l'emplacement courant de la sous-zone partielle (132) sur le substrat (106) et/ou de l'intensité courante de l'au moins un faisceau laser (124) sur le substrat (106) en fonction du changement d'épaisseur de couche mesuré et/ou de l'épaisseur de couche mesurée.

12. Procédé de production de films minces nano-, micro-, poly-, multi- ou monocristallins comprenant les étapes de procédé suivantes :
a) l'introduction d'un substrat (106) à revêtir dans une chambre à vide (110) dans une direction de traversée (136),
b) le dépôt physique en phase vapeur comprenant l'évaporation par faisceau d'électrons ou la pulvérisation cathodique d'une couche sur une zone partielle (130) d'une surface (126) du substrat (106) et la cristallisation par laser simultanée d'au moins une sous-zone partielle (132) de la zone partielle en cours de revêtement (130) de la surface (126) du substrat (106) au moyen d'au moins un faisceau laser (124) tout en déplaçant de façon continue ou discontinue le substrat (106) dans la direction de traversée (136),
c) la décharge du substrat revêtu (106) de la chambre à vide (110) dans la direction de traversée (136).

13. Procédé selon la revendication 12, **caractérisé en ce que** le dépôt physique en phase vapeur est réalisé à une vitesse de croissance de couche supérieure à 100 nm/min, de préférence supérieure à 1000 nm/min, bien mieux encore supérieure à 2000 nm/min.

14. Procédé selon l'une des revendications 12 et 13, **caractérisé en ce que** le substrat (106) est déplacé pendant l'étape de procédé b) dans la direction de traversée (136) à une vitesse moyenne supérieure à 0,5 m/min, de préférence supérieure à 2 m/min.

15. Procédé selon l'une des revendications 12 à 14, **caractérisé en ce que** l'au moins un des faisceaux lasers (124) est dirigé vers l'emplacement du substrat (106) sur lequel précisément une épaisseur de couche prédéterminée a été déposée.

16. Procédé selon la revendication 15, **caractérisé en ce que** l'épaisseur de couche prédéterminée se situe entre 50 nm et 1000 nm, de préférence entre 100 nm et 500 nm, bien mieux encore entre 100 nm et 300 nm.

17. Procédé selon l'une ou l'autre des revendications 15 et 16, **caractérisé en ce que** l'au moins un des faisceaux lasers (124) est dirigé vers l'emplacement (132, 444, 446) du substrat (106) sur lequel précisément une épaisseur de couche prédéterminée supplémentaire a été déposée après un éclairage avec l'au moins un faisceau laser (124).
